(19) **Europäisches Patentamt / European Patent Office / Office européen des brevets**

(11) **EP 2 156 160 B1**

(12) **FASCICULE DE BREVET EUROPEEN**

(45) Date de publication et mention de la délivrance du brevet:
**25.12.2013 Bulletin 2013/52**

(21) Numéro de dépôt: **08805927.4**

(22) Date de dépôt: **04.06.2008**

(51) Int Cl.:
*F02P 9/00* *(2006.01)*    *F02P 17/12* *(2006.01)*
*H01T 13/58* *(2011.01)*    *F02D 41/02* *(2006.01)*
*G01R 31/00* *(2006.01)*

(86) Numéro de dépôt international:
**PCT/FR2008/050986**

(87) Numéro de publication internationale:
**WO 2009/004204 (08.01.2009 Gazette 2009/02)**

(54) **DIAGNOSTIC DE L'ETAT D'ENCRASSEMENT DES BOUGIES D'UN SYSTEME D'ALLUMAGE RADIOFREQUENCE**

DIAGNOSE DES VERSCHMUTZUNGSZUSTANDES VON ZÜNDKERZEN IN EINEM FUNKFREQUENZZÜNDUNGSSYSTEM

DIAGNOSIS OF THE FOULING CONDITION OF SPARKPLUGS IN A RADIOFREQUENCY IGNITION SYSTEM

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **12.06.2007 FR 0704190**

(43) Date de publication de la demande:
**24.02.2010 Bulletin 2010/08**

(73) Titulaire: **Renault S.A.S.**
**92100 Boulogne-Billancourt (FR)**

(72) Inventeurs:
• **DELORAINE, Franck**
  **F-92260 Fontenay aux Roses (FR)**
• **COUILLAUD, Julien**
  **F-91200 Athis Mons (FR)**
• **JAFFREZIC, Xavier**
  **F-78140 Velizy-Villacoublay (FR)**

(74) Mandataire: **Rougemont, Bernard et al**
**Renault s.a.s**
**Technocentre**
**Sce 00267 TCR GRA 2 36**
**1, Avenue du Golf**
**78288 Guyancourt (FR)**

(56) Documents cités:
**FR-A- 2 680 833**    **FR-A- 2 859 869**
**US-A- 4 846 129**    **US-A- 5 187 580**

Printed by Jouve, 75001 PARIS (FR)

**Description**

La présente invention concerne, de façon générale, les systèmes de génération de plasma entre deux électrodes d'une bougie, utilisée notamment pour l'allumage radiofréquence commandé d'un mélange gazeux dans des chambres de combustion d'un moteur à combustion interne.

L'invention concerne plus particulièrement un dispositif d'allumage radiofréquence, comprenant :

- des moyens de commande aptes à générer un signal de commande d'allumage,
- un circuit d'alimentation, commandé par le signal de commande d'allumage, pour appliquer une tension d'alimentation sur une interface de sortie du circuit d'alimentation à la fréquence définie par le signal de commande,
- au moins un résonateur de génération de plasma connecté sur l'interface de sortie du circuit d'alimentation et apte à générer une étincelle entre deux électrodes dudit résonateur lors d'une commande d'allumage

Pour une application à l'allumage automobile à génération de plasma, on utilise des bobines-bougies (décrites en détail dans les demandes de brevet suivantes déposées au nom de la demanderesse FR 03-10766, FR 03-10767 et FR 03-10768), modélisées par un résonateur 1 (voir figure 1), dont la fréquence de résonance $F_c$ est supérieure à 1 MHz, et typiquement voisine de 5 MHz. Le résonateur comprend en série une résistance R, une inductance L et une capacité C. Des électrodes d'allumage 10 et 12 de la bobine-bougie sont connectées aux bornes de la capacité C du résonateur, permettant de générer des décharges multi-filamentaires pour initier la combustion du mélange dans les chambres de combustion du moteur, lorsque le résonateur est alimenté.

En effet, lorsque le résonateur est alimenté par une haute tension à sa fréquence de résonance $F_c$ $(1 / (2\pi \sqrt{L*C}))$, l'amplitude aux bornes de la capacité C est amplifiée de telle sorte que des décharges multi-filamentaires se développent entre les électrodes, sur des distances de l'ordre du centimètre, à forte pression et pour des tensions de crête inférieures à 20 kV.

On parle alors d'étincelles ramifiées, dans la mesure où elles impliquent la génération simultanée d'au moins plusieurs lignes ou chemin d'ionisation dans un volume donné, leurs ramifications étant en outre omnidirectionnelles.

Cette application à l'allumage radiofréquence nécessite l'utilisation d'une alimentation, capable de générer des impulsions de tension, typiquement de l'ordre de 100 ns, pouvant atteindre des amplitudes de l'ordre de 1 kV, à une fréquence très proche de la fréquence de résonance du résonateur de génération de plasma de la bobine-bougie radiofréquence. Plus la différence entre la fréquence de résonance du résonateur et la fréquence de fonctionnement de l'alimentation est réduite, plus le coefficient de surtension du résonateur (rapport entre l'amplitude de sa tension de sortie et sa tension d'entrée) est élevé.

La figure 2 illustre schématiquement une telle alimentation, détaillée par ailleurs dans la demande de brevet FR 03-10767. L'alimentation met classiquement en oeuvre un montage dit « amplificateur de puissance Classe E ». Ce type de convertisseur DC/AC permet de créer les impulsions de tension avec les caractéristiques précitées.

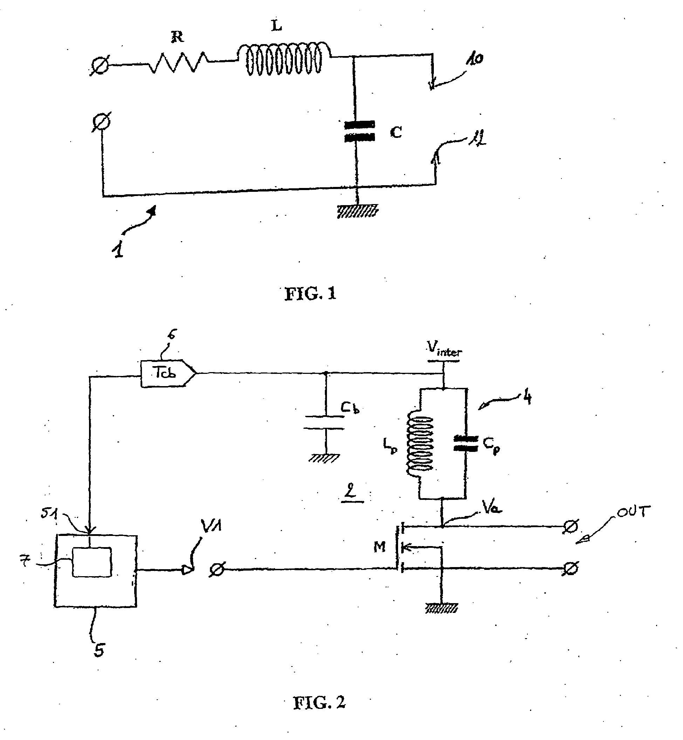

Selon le mode de réalisation de la figure 2, un tel circuit d'alimentation 2 présente un transistor MOSFET de puissance M et un circuit résonant parallèle 4 comprenant une inductance Lp en parallèle avec une capacité Cp. Le transistor M est utilisé comme interrupteur pour commander les commutations aux bornes du circuit résonant parallèle et du résonateur 1 de génération de plasma destiné à être connecté sur une interface de sortie OUT du circuit d'alimentation.

Des moyens de commande 5 du circuit d'alimentation sont adaptés à générer un signal logique de commande V1, destiné à être appliqué sur la grille du transistor M, à une fréquence qui doit être sensiblement calée sur la fréquence de résonance du résonateur 1.

Le dispositif d'allumage tel qu'il vient d'être décrit est alimenté par une tension Vinter régnant aux bornes d'une capacité Cb du circuit d'alimentation. La tension Vinter peut avantageusement être fournie par une alimentation haute tension reliée à la capacité Cb, typiquement un convertisseur DC/DC.

Ainsi, à proximité de sa fréquence de résonance, le résonateur parallèle 4 transforme la tension d'alimentation continue Vinter en une tension périodique amplifiée Va, correspondant à la tension d'alimentation multipliée par le coefficient de surtension du résonateur parallèle et appliquée sur l'interface de sortie du circuit d'alimentation au niveau du drain du transistor interrupteur M.

L'interrupteur M applique alors la tension d'alimentation amplifiée Va sur la sortie de l'alimentation, à la fréquence définie par le signal de commande V1, que l'on cherche à rendre la plus proche possible de la fréquence de résonance de la bobine-bougie. En effet, lors d'une commande d'allumage, afin de pouvoir mettre en résonance le dispositif d'allumage radiofréquence et maximiser la tension aux bornes des électrodes de la bobine-bougie afin d'obtenir l'étincelle attendue, la bobine-bougie doit être pilotée sensiblement à sa fréquence de résonance.

Dans le contexte de l'allumage commandé dans un cylindre de moteur à combustion, la bobine-bougie est vissée sur le moteur et son électrode centrale est logée dans la chambre de combustion du cylindre correspondant du moteur. Or, au fur et à mesure des décharges plasma générées par la bobine-bougie, un phénomène d'encrassement de la bougie est susceptible de se produire, qui se caractérise par le dépôt des déchets de la combustion sous forme de suies sur l'électrode centrale et sur la céramique autour de celle-ci. Ce phénomène, au-delà d'un certain niveau d'encrassement, nuit au bon fonctionnement de la bobine-bougie et entraîne des ratés d'allumage.

Jusqu'alors, la manière la plus répandue de diagnostiquer l'état d'encrassement des électrodes de la bobine-bougie consiste à démonter celle-ci de son emplacement dans la chambre de combustion et de constater, par une analyse visuelle, son état d'encrassement.

La présente invention vise à améliorer le diagnostic de l'état d'encrassement des électrodes de la bobine-bougie radiofréquence.

Le dispositif selon l'invention, par ailleurs conforme à la définition qu'en donne le préambule ci-dessus, est essentiellement caractérisée en ce qu'il comprend :

- des moyens de mesure d'un paramètre électrique représentatif d'une variation de la tension d'alimentation du résonateur au cours d'une commande d'allumage, et
- un module de détermination d'un état d'encrassement des électrodes, en fonction du paramètre électrique mesuré et d'une valeur de référence prédéterminée.

De préférence, le paramètre électrique est la tension aux bornes d'une capacité de stockage du circuit d'alimentation, adaptée pour être chargée à la tension d'alimentation avant une commande d'allumage.

Selon un mode de réalisation, le circuit d'alimentation comprend un interrupteur commandé par le signal de commande d'allumage pour appliquer la tension d'alimentation sur l'interface de sortie à la fréquence définie par le signal de commande.

Avantageusement, la fréquence de commande est sensiblement égale à la fréquence de résonance du résonateur de génération de plasma.

Le résonateur de génération de plasma utilisé est adapté pour réaliser un allumage dans l'une des mises en oeuvre suivantes : allumage commandé de moteur à combustion, allumage dans un filtre à particules, allumage de décontamination dans un système de climatisation.

Avantageusement, le dispositif selon l'invention comprend un moyen d'information de l'état d'encrassement des électrodes implanté au niveau d'une Interface Homme Machine d'un véhicule automobile.

L'invention concerne également un procédé de diagnostic d'un état d'encrassement des électrodes d'allumage d'au moins un résonateur de génération de plasma radiofréquence connecté sur une interface de sortie d'un circuit d'alimentation configuré pour délivrer sur ladite interface de sortie une tension d'alimentation à une fréquence de commande pendant une commande d'allumage, ledit résonateur étant apte à générer une étincelle entre les deux électrodes lors de la commande d'allumage, ledit procédé étant caractérisé en ce qu'il comprend les étapes de :

- mesure, lors de la commande d'allumage, d'une variation d'un paramètre électrique représentatif de la variation de la tension d'alimentation,
- comparaison de la variation mesurée avec une valeur de référence prédéterminée ;
- détermination de l'état d'encrassement des électrodes en fonction de la différence entre la variation mesurée et la valeur de référence.

De préférence, on mesure la variation de la tension aux bornes d'une capacité de stockage du circuit d'alimentation, ladite capacité étant chargée à la tension d'alimentation avant la commande d'allumage.

Selon un mode de réalisation, la variation mesurée découle de la différence entre la mesure de la tension aux bornes de la capacité de stockage en début et en fin de la commande d'allumage.

Avantageusement, la valeur de référence correspond à ladite variation avant encrassement.

De préférence, le procédé comprend une étape consistant à informer un utilisateur de l'état d'encrassement. Avantageusement, une telle information fournie à l'utilisateur permet de l'avertir d'une défaillance d'allumage à venir.

D'autres caractéristiques et avantages de la présente invention apparaîtront plus clairement à la lecture de la description suivante donnée à titre d'exemple illustratif et non limitatif et faite en référence aux figures annexées dans lesquelles :

- la figure 1 est un schéma d'un résonateur modélisant une bobine-bougie radiofréquence de génération de plasma;
- la figure 2 est un schéma illustrant une alimentation, utilisée pour la commande du résonateur de la bobine bougie de la figure 1 ;
- la figure 3 est un organigramme illustrant un exemple de mise en oeuvre du procédé de diagnostic de l'état d'encrassement des électrodes d'une bobine-bougie ;
- la figure 4 est un schéma illustrant l'effet de l'encrassement des électrodes d'allumage sur la variation de la tension aux bornes de la capacité Cb de l'alimentation pendant une commande d'allumage.

Le dispositif d'allumage selon l'invention comprend des moyens de mesure 6 d'un paramètre électrique représentatif d'une variation de la tension d'alimentation du résonateur de génération de plasma au cours d'une commande d'allumage, et un module 7 susceptible de déterminer un état d'encrassement des électrodes d'allumage, en fonction du paramètre électrique mesuré et d'une valeur de référence prédéterminée.

Le paramètre électrique en question est par exemple la tension $T_{cb}$ aux bornes de la capacité de stockage Cb du circuit d'alimentation, mesurée à au moins deux instants déterminés de la commande d'allumage.

Ainsi, à deux instants déterminés de la commande d'allumage, choisis par exemple au début et à la fin ou juste après celle-ci, on réalise une mesure de la déchéance de la tension aux bornes de Cb, par exemple en utilisant le voltmètre 6 mesurant la tension $T_{cb}$. Le module 7, qui peut par exemple être intégré aux moyens de commande 5, relève alors cette mesure électrique par l'intermédiaire d'une interface de réception 51 et détermine alors un état d'encrassement des électrodes d'allumage en fonction de cette mesure électrique de variation de tension et de la valeur de référence prédéterminée, comme il sera expliqué plus en détail par la suite.

Le choix de la mesure de la tension aux bornes de la capacité Cb à un instant déterminé d'une commande d'allumage pour diagnostiquer l'état d'encrassement des électrodes d'allumage, découle des calculs suivant :

$T_{cb}(t)$ étant la tension aux bornes de la capacité Cb en fonction du temps ;

$V_m(t)$ étant la tension aux bornes de la capacité C en fonction du temps ;

A l'instant t=0, le signal de commande V1 est appliqué sur la grille de commande de l'interrupteur M, permettant ainsi l'application de la haute tension aux bornes du résonateur de la bobine-bougie, à la fréquence définie par le signal de commande V1.

A l'instant t=D, consécutif à l'application du signal de commande d'allumage pendant la durée D, l'étincelle se produit entre les électrodes d'allumage 10 et 12.

Un bilan énergétique de la bobine-bougie montre :

$$\frac{1}{2} \times Cb \times ([Tcb(t=0)]^2 - [Tcb(t=D)]^2) = K \times \frac{1}{2} \times C \times ([Vm(t=D)]^2 - [Vm(t=0)]^2)$$

Avec $Vm(t=0) = 0$

$$Vm(t=D) = \sqrt{\frac{Cb}{K \times C}([Tcb(t=0)]^2 - [Tcb(t=D)]^2)}$$

Soient :

$T_{cb\_n}(t)$ la tension aux bornes de la capacité Cb en fonction du temps lors d'une commande d'allumage, lorsque la bobine-bougie est neuve, c'est-à-dire avant encrassement des électrodes d'allumage ;

$T_{cb\_e}(t)$ la tension aux bornes de la capacité Cb en fonction du temps lors d'une commande d'allumage, lorsque les électrodes d'allumage de la bobine-bougie sont encrassées ;

$V_{m\_n}(t)$ la tension aux bornes de la capacité C du résonateur en fonction du temps lors d'une commande d'allumage, lorsque la bobine-bougie est neuve, c'est-à-dire avant encrassement des électrodes d'allumage, et

$V_{m\_e}(t)$ la tension aux bornes de la capacité C du résonateur en fonction du temps lors d'une commande d'allumage, lorsque les électrodes d'allumage de la bobine-bougie sont encrassées, il vient d'après l'équation précédente :

$$Vm\_n(t=D) = \sqrt{\frac{Cb}{C}([Tcb\_n(t=0)]^2 - [Tcb\_n(t=D)]^2)}$$

Et

$$Vm\_e(t = D) = \sqrt{\frac{Cb}{C}([Tcb\_e(t = 0)]^2 - [Tcb\_e(t = D)]^2}$$

Par conséquent, avec $V_{m\_e}(t) < V_{m\_n}(t)$, on peut en déduire l'équation suivante du diagnostic de l'état d'encrassement des électrodes d'allumage pour $T_{cb\_n}(t=0) = T_{cb\_e}(t=0)$ :

$$T_{cb\_e}(t=D) > T_{cb\_n}(t=D)$$

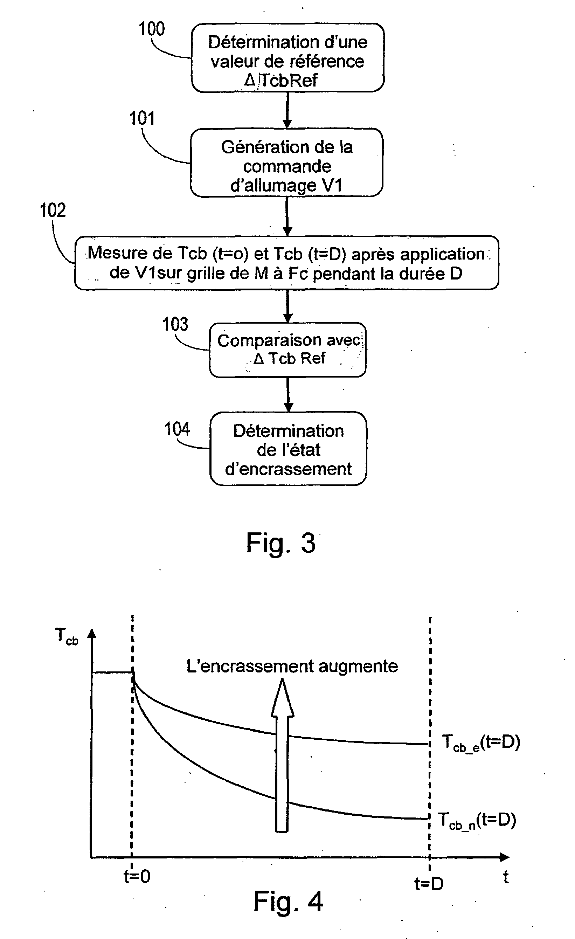

Autrement dit, comme illustré à la figure 4, la déchéance de tension aux bornes de la capacité Cb pendant une commande d'allumage (caractérisée par la différence entre la valeur de la tension aux bornes de Cb prise à l'instant t=D et la valeur de cette tension prise à l'instant t=0) est d'autant plus faible que l'encrassement des électrodes d'allumage augmente.

Le bilan énergétique dont il est fait état ci-dessus peut être réalisé pour une fréquence de commande sensiblement égale à la fréquence de résonance du résonateur. En effet, la déchéance de tension aux bornes de la capacité Cb pendant une commande d'allumage étant maximale lorsque le résonateur de la bobine-bougie radiofréquence est piloté à sa fréquence de résonance, la mesure de tension réalisée aux bornes de la capacité Cb lors d'une commande d'allumage, utilisée pour diagnostiquer l'état d'encrassement des électrodes d'allumage, est d'autant plus significative.

La figure 3 illustre un exemple d'algorithme de diagnostic de l'état d'encrassement des électrodes d'allumage, basé sur la mesure de la déchéance de tension aux bornes de la capacité Cb de l'alimentation lors d'une commande d'allumage.

Une première étape 100 consiste à déterminer une valeur de référence de déchéance de tension $\Delta T_{cb}Ref$ aux bornes de la capacité Cb pour une bougie neuve, i.e. avant encrassement des électrodes d'allumage, entre deux instants déterminés d'une commande d'allumage, dans des conditions données d'allumage, s'agissant de la valeur de la tension d'alimentation devant être appliquée, de la durée D d'application du signal de commande V1 et de sa fréquence de commande, choisie par exemple sensiblement égale à la fréquence de résonance du résonateur.

Lors d'une étape 101, on applique une valeur de tension identique et un signal de commande V1 d'une durée D identique est généré à la même fréquence de commande, et est appliqué sur la grille de commande du transistor M, afin de commander le résonateur de génération de plasma.

Lors d'une étape 102, on mesure la variation de tension aux bornes de la capacité Cb aux mêmes instants déterminés de la commande d'allumage que ceux choisi pour la détermination de la valeur de référence. Par exemple, ces instants correspondent à l'instant t=0 et t=D de l'application de la commande d'allumage, où la déchéance de la tension aux bornes de la capacité Cb est la plus significative. On mesure donc la déchéance de tension $T_{cb}(t=0)-T_{cb}(t=D)$, correspondant à la variation de la tension aux bornes de Cb en début et en fin de commande d'allumage, à l'instant t=0 et t=D d'application du signal de commande V1.

Pour autant, l'essentiel est que la valeur de variation mesurée et la valeur de référence soient représentatives des mêmes instants d'une commande d'allumage, dans des conditions d'application identiques par ailleurs.

Puis, lors d'une étape 103, on compare cette valeur de variation mesurée $T_{cb}(t=0)-T_{cb}(t=D)$ à la valeur de référence prédéterminée $\Delta TcbRef$.

Lors d'une étape 104, on détermine l'état d'encrassement des électrodes d'allumage, selon que l'écart calculé entre la valeur de la variation mesurée et la valeur de référence dépasse un certain seuil.

En l'occurrence, en fonction notamment du type de bobine-bougie utilisée et des conditions de fonctionnement du moteur, l'homme de l'art saura identifier différents seuils au-delà desquels respectivement l'écart calculé est par exemple caractéristique d'un état faiblement encrassé, encrassé ou encore fortement encrassé des électrodes d'allumage.

En variante, on pourrait envisager de réaliser des mesures de la tension aux bornes de la capacité Cb à chaque instant d'une commande d'allumage. Ces mesures successives de la déchéance de tension aux bornes de Cb pendant une commande d'allumage sauront alors être utilisées de façon optimale par l'homme de l'art pour diagnostiquer l'état d'encrassement des électrodes d'allumage.

Dans une application à l'allumage automobile à génération de plasma, on se propose d'utiliser le diagnostic sur l'état d'encrassement des bougies ainsi obtenu pour avertir le conducteur d'une panne à venir sur le système d'allumage. Aussi, un moyen d'information de l'état d'encrassement des bougies est implanté au moins partiellement à l'intérieur de l'habitacle de l'automobile. Par exemple, un voyant lumineux de défaut est allumé au niveau de l'Interface Homme Machine du véhicule pour avertir le conducteur d'une défaillance d'allumage à venir sur le système d'allumage, selon l'état d'encrassement diagnostiqué.

On peut également envisager de mettre en oeuvre un mode dégradé pour les bobines-bougies dont le diagnostic sur l'état d'encrassement des électrodes indique une panne à venir, dans lequel la bobine-bougie est pilotée à une tension spécifique, en paramétrant son amplitude, sa fréquence et sa durée, de manière à ralentir la dégradation du composant.

**Revendications**

**1.** Dispositif d'allumage radiofréquence, comprenant :

- des moyens de commande (5) apte à générer un signal de commande d'allumage (V1),
- un circuit d'alimentation (2), commandé par le signal de commande d'allumage (V1), pour appliquer une tension d'alimentation sur une interface de sortie (OUT) du circuit d'alimentation à la fréquence définie par le signal de commande,
- au moins un résonateur de génération de plasma (1) connecté sur l'interface de sortie du circuit d'alimentation et apte à générer une étincelle entre deux électrodes d'allumage (10, 12) dudit résonateur lors d'une commande d'allumage ;

ledit dispositif étant **caractérisé en ce qu'**il comprend :

- des moyens de mesure (6) d'un paramètre électrique représentatif d'une variation de la tension d'alimentation du résonateur au cours d'une commande d'allumage,
- un module de détermination (7) d'un état d'encrassement des électrodes, en fonction du paramètre électrique mesuré et d'une valeur de référence prédéterminée.

**2.** Dispositif selon la revendication 1, **caractérisé en ce que** le paramètre électrique est la tension aux bornes d'une capacité (Cb) de stockage du circuit d'alimentation, adaptée pour être chargée à la tension d'alimentation avant une commande d'allumage.

**3.** Dispositif selon la revendication 1 ou 2, caractérisé en ce le circuit d'alimentation comprend un interrupteur (M) commandé par le signal de commande d'allumage (V1) pour appliquer la tension d'alimentation sur l'interface de sortie à la fréquence définie par le signal de commande.

**4.** Dispositif selon l'une quelconque des revendications précédentes, **caractérisé en ce que** la fréquence de commande est sensiblement égale à la fréquence de résonance du résonateur de génération de plasma.

**5.** Dispositif selon l'une quelconque des revendications précédentes, dans lequel le résonateur de génération de plasma est adapté pour réaliser un allumage dans l'une des mises en oeuvre suivantes : allumage commandé de moteur à combustion, allumage dans un filtre à particules, allumage de décontamination dans un système de climatisation.

**6.** Dispositif selon l'une quelconque des revendications précédentes, **caractérisé en ce qu'**il comprend un moyen d'information de l'état d'encrassement des électrodes implanté au niveau d'une Interface Homme machine d'un véhicule automobile.

**7.** Procédé de diagnostic d'un état d'encrassement des électrodes d'allumage (10, 12) d'au moins un résonateur de génération de plasma radiofréquence connecté sur une interface de sortie (OUT) d'un circuit d'alimentation (2) configuré pour délivrer sur ladite interface de sortie une tension d'alimentation à une fréquence de commande pendant une commande d'allumage, ledit résonateur étant apte à générer une étincelle entre les deux électrodes lors de la commande d'allumage, ledit procédé étant **caractérisé en ce qu'**il comprend les étapes de :

- mesure (102), lors de la commande d'allumage, d'une variation d'un paramètre électrique représentatif de la variation de la tension d'alimentation,
- comparaison (103) de la variation mesurée avec une valeur de référence prédéterminée (100);
- détermination (104) de l'état d'encrassement des électrodes en fonction de la différence entre la variation mesurée et la valeur de référence.

**8.** Procédé selon la revendication 7, **caractérisé en ce qu'**on mesure la variation de la tension aux bornes d'une capacité de stockage (Cb) du circuit d'alimentation, ladite capacité étant chargée à la tension d'alimentation avant la commande d'allumage.

9. Procédé selon la revendication 8, **caractérisé en ce que** la variation mesurée découle de la différence entre la mesure de la tension aux bornes de la capacité de stockage (Cb) en début et en fin de la commande d'allumage.

10. Procédé selon l'une quelconque des revendications 7 à 9, **caractérisé en ce que** la valeur de référence correspond à ladite variation avant encrassement.

11. Procédé selon l'une quelconque des revendications 7 à 10, **caractérisé en ce qu'**il comprend une étape consistant à informer un utilisateur de l'état d'encrassement, pour l'avertir d'une défaillance d'allumage à venir.

**Patentansprüche**

1. Hochfrequenz-Zündvorrichtung, die enthält:

   - Steuereinrichtungen (5), die ein Zündsteuersignal (V1) erzeugen können,
   - eine vom Zündsteuersignal (V1) gesteuerte Versorgungsschaltung (2), um eine Versorgungsspannung an eine Ausgangsschnittstelle (OUT) der Versorgungsschaltung mit der vom Steuersignal definierten Frequenz anzulegen,
   - mindestens einen Plasmaerzeugungsresonator (1), der mit der Ausgangsschnittstelle der Versorgungsschaltung verbunden ist und einen Funken zwischen zwei Zündelektroden (10, 12) des Resonators bei einer Zündsteuerung erzeugen kann;

   wobei die Vorrichtung **dadurch gekennzeichnet ist, dass** sie enthält:

   - Einrichtungen zur Messung (6) eines elektrischen Parameters, der für eine Änderung der Versorgungsspannung des Resonators während einer Zündsteuerung repräsentativ ist,
   - ein Modul zur Bestimmung (7) eines Verschmutzungszustands der Elektroden abhängig vom gemessenen elektrischen Parameter und von einem vorbestimmten Bezugswert.

2. Vorrichtung nach Anspruch 1, **dadurch gekennzeichnet, dass** der elektrische Parameter die Spannung an den Klemmen eines Speicherkondensators (Cb) der Versorgungsschaltung ist, der geeignet ist, um vor einer Zündsteuerung auf die Versorgungsspannung geladen zu werden.

3. Vorrichtung nach Anspruch 1 oder 2, **dadurch gekennzeichnet, dass** die Versorgungsschaltung einen vom Zündsteuersignal (V1) gesteuerten Unterbrecher (M) enthält, um die Versorgungsspannung an die Ausgangsschnittstelle mit der vom Steuersignal definierten Frequenz anzulegen.

4. Vorrichtung nach einem der vorhergehenden Ansprüche, **dadurch gekennzeichnet, dass** die Steuerfrequenz im Wesentlichen gleich der Resonanzfrequenz des Plasmaerzeugungsresonators ist.

5. Vorrichtung nach einem der vorhergehenden Ansprüche, wobei der Plasmaerzeugungsresonator geeignet ist, um eine Zündung bei einer der folgenden Anwendungen durchzuführen: Fremdzündung eines Verbrennungsmotors, Zündung in einem Partikelfilter, Dekontaminierungszündung in einer Klimaanlage.

6. Vorrichtung nach einem der vorhergehenden Ansprüche, **dadurch gekennzeichnet, dass** sie eine Einrichtung zur Information über den Verschmutzungszustand der Elektroden enthält, die im Bereich einer Mensch-Maschine-Schnittstelle eines Kraftfahrzeugs eingebaut ist.

7. Verfahren zur Diagnose eines Verschmutzungszustands der Zündelektroden (10, 12) mindestens eines Hochfrequenz-Plasmaerzeugungsresonators, der mit einer Ausgangsschnittstelle (OUT) einer Versorgungsschaltung (2) verbunden ist, die konfiguriert ist, um an die Ausgangsschnittstelle eine Versorgungsspannung auf einer Steuerfrequenz während einer Zündsteuerung zu liefern, wobei der Resonator einen Funken zwischen den zwei Elektroden bei der Zündsteuerung erzeugen kann, wobei das Verfahren **dadurch gekennzeichnet ist, dass** es die folgenden Schritte enthält:

- Messen (102), während der Zündsteuerung, einer Änderung eines elektrischen Parameters, der für die Änderung der Versorgungsspannung repräsentativ ist,
- Vergleich (103) der gemessenen Änderung mit einem vorbestimmten Bezugswert (100);
- Bestimmung (104) des Verschmutzungszustands der Elektroden abhängig von der Differenz zwischen der gemessenen Änderung und dem Bezugswert.

8. Verfahren nach Anspruch 7, **dadurch gekennzeichnet, dass** die Änderung der Spannung an den Klemmen eines Speicherkondensators (Cb) der Versorgungsschaltung gemessen wird, wobei der Kondensator mit der Versorgungsspannung vor der Zündsteuerung geladen wird.

9. Verfahren nach Anspruch 8, **dadurch gekennzeichnet, dass** die gemessene Änderung sich aus der Differenz zwischen dem Messwert der Spannung an den Klemmen des Speicherkondensators (Cb) am Anfang und am Ende der Zündsteuerung ergibt.

10. Verfahren nach einem der Ansprüche 7 bis 9, **dadurch gekennzeichnet, dass** der Bezugswert der Änderung vor der Verschmutzung entspricht.

11. Verfahren nach einem der Ansprüche 7 bis 10, **dadurch gekennzeichnet, dass** es einen Schritt enthält, der darin besteht, einen Benutzer über den Verschmutzungszustand zu informieren, um ihn vor einem künftigen Zündversagen zu warnen.

## Claims

1. Microwave ignition device comprising:

   - a control means (5) capable of generating an ignition command signal (V1),
   - a supply circuit (2), controlled by the ignition command signal (V1), in order to apply a supply voltage to an output interface (OUT) of the supply circuit at the frequency defined by the command signal,
   - at least one plasma-generation resonator (1) connected to the output interface of the supply circuit and capable of generating a spark between two ignition electrodes (10, 12) of said resonator;

   said device being **characterized in that** it comprises:

   - means (6) for measuring an electric parameter representative of a change in the supply voltage of the resonator during an ignition command,
   - a module (7) for determining a state of fouling of the electrodes, as a function of the electric parameter measured and of a predetermined reference value.

2. Device according to Claim 1, **characterized in that** the electric parameter is the voltage at the terminals of a storage capacitor (Cb) of the supply circuit, suitable for being charged to the supply voltage before an ignition command.

3. Device according to Claim 1 or 2, **characterized in that** the supply circuit comprises a switch (M) controlled by the ignition command signal (V1) in order to apply the supply voltage to the output interface at the frequency defined by the command signal.

4. Device according to any one of the preceding claims, **characterized in that** the command frequency is substantially equal to the resonance frequency of the plasma-generation resonator.

5. Device according to any one of the preceding claims, wherein the plasma-generation resonator is suitable for carrying out an ignition in one of the following applications: controlled ignition of a combustion engine, ignition in a particle filter, decontamination ignition in an air-conditioning system.

6. Device according to any one of the preceding claims, **characterized in that** it comprises a means of supplying information on the state of fouling of the electrodes, said means being installed on a Man-Machine Interface of a motor vehicle.

7. Method for diagnosing a state of fouling of the ignition electrodes (10, 12) of at least one microwave plasma-generation resonator connected to an output interface (OUT) of a supply circuit (2) configured to deliver to said output interface a supply voltage at a command frequency during an ignition command, said resonator being capable of generating a spark between the two electrodes during the ignition command, said method being **characterized in that** it comprises the steps of:

- measuring (102), during the ignition command, a change in an electric parameter representative of the change in the supply voltage,
- comparing (103) the measured change with a predetermined reference value (100);
- determining (104) the state of fouling of the electrodes as a function of the difference between the measured change and the reference value.

8. Method according to Claim 7, **characterized in that** the change in the voltage at the terminals of a storage capacitor (Cb) of the supply circuit is measured, said capacitor being charged to the supply voltage before the ignition command.

9. Method according to Claim 8, **characterized in that** the measured change arises from the difference between the measurement of the voltage at the terminals of the storage capacitor (Cb) at the beginning and at the end of the ignition command.

10. Method according to any one of Claims 7 to 9, **characterized in that** the reference value corresponds to said change before fouling.

11. Method according to any one of Claims 7 to 10, **characterized in that** it comprises a step consisting in informing a user of the state of fouling, in order to notify him of a future ignition failure.

**FIG. 1**

**FIG. 2**

```
                    ┌─────────────────────┐
                100 │  Détermination d'une │
                    │  valeur de référence │
                    │      ΔTcbRef         │
                    └─────────────────────┘
                              │
                              ▼
                    ┌─────────────────────┐
                101 │   Génération de la   │
                    │     commande         │
                    │   d'allumage V1      │
                    └─────────────────────┘
                              │
                              ▼
        ┌──────────────────────────────────────────────────┐
    102 │ Mesure de Tcb (t=o) et Tcb (t=D) après application │
        │   de V1sur grille de M à Fc pendant la durée D     │
        └──────────────────────────────────────────────────┘
                              │
                              ▼
                    ┌─────────────────────┐
                103 │   Comparaison avec   │
                    │      Δ Tcb Ref       │
                    └─────────────────────┘
                              │
                              ▼
                    ┌─────────────────────┐
                104 │   Détermination      │
                    │     de l'état        │
                    │   d'encrassement     │
                    └─────────────────────┘
```

## Fig. 3

$T_{cb}$

L'encrassement augmente

$T_{cb\_e}(t=D)$

$T_{cb\_n}(t=D)$

t=0   t=D   t

## Fig. 4

**RÉFÉRENCES CITÉES DANS LA DESCRIPTION**

**Documents brevets cités dans la description**

- FR 0310766
- FR 0310767
- FR 0310768